# EUROPÄISCHE PATENTANMELDUNG

(11) **EP 4 783 209 A1**
(43) Veröffentlichungstag der Anmeldung: **29.07.2026**
(21) Anmeldenummer: 25220431.8
(22) Anmeldetag: 03.12.2025
(51) Int. Cl.: H01H 1/58, H01H 9/54, H01H 50/54

(54) **SCHALTGERÄT**

(30) Priorität: 27.01.2025 DE 102025102792
(71) Anmelder: Ellenberger & Poensgen GmbH, 90518 Altdorf (DE)
(72) Erfinder: HOLBE, Stefan, 90425 Nürnberg (DE); KÖPF, Hendrik-Christian, 90480 Nürnberg (DE); KAISER, Julian, 91058 Erlangen (DE)
(74) Vertreter: FDST Patentanwälte

(57) **Zusammenfassung**

Die Erfindung betrifft ein Schaltgerät (10) mit einem mechanischen Schalter (39), der eine erste Stromschiene (26) mit einem ersten Festkontakt (32) und eine zweite Stromschiene (40) mit einem ersten Bewegkontakt (42) aufweist, der dem ersten Festkontakt (32) zugordnet ist. Das Schaltgerät (10) umfasst ferner eine Leiterplatte (24), an der die erste Stromschiene (26) montiert ist.

## Beschreibung

Die Erfindung betrifft ein Schaltgerät. Das Schaltgerät umfasst einen mechanischen Schalter, der eine erste Stromschiene mit einem ersten Festkontakt und eine zweite Stromschiene mit einem ersten Bewegkontakt umfasst.

Üblicherweise werden Schutzschalter zur Absicherung einer elektrischen Leitung oder eines Geräts gegenüber einer Fehlfunktion des zugeordneten Stromkreises herangezogen, beispielsweise einer übermäßig anliegenden elektrischen Spannung oder eines übermäßigen fließenden elektrischen Stroms. Dieser tritt beispielsweise bei einer Vorschädigung des abzusichernden Geräts oder der elektrischen Leitung auf. In diesem Fall erfolgt mittels des Schutzschalters ein Unterbrechen des Stromflusses, sodass eine weitere Beschädigung vermieden wird.

Zum Unterbrechen des Stromflusses weist der Schutzschalter einen Schalter auf. Somit stellt der Schutzschalter eine Ausbildung eines Schaltgeräts dar. Zur Bereitstellung eines Berührschutzes und zur leichten Montage ist der Schalter dabei innerhalb eines Gehäuses angeordnet. Der Schalter ist beispielsweise als Halbleiterschalter ausgestaltet. Dieser weist konstruktionsbedingt einen Innenwiderstand auf, weswegen dieser bei Betrieb erwärmt wird, zumindest wenn ein vergleichsweise großer elektrischer Strom geführt wird. Somit ist eine Kühlung erforderlich. Auch ist ein Wirkungsgrad verringert. In einer Alternative hierzu ist der Schalter mechanisch ausgestaltet und in Wirkverbindung mit einem Antrieb, der beispielsweise einen Elektromagneten umfasst. Mittels Bestromung des Antriebs ist es somit möglich, den Schaltzustand des Schalters zu verändern.

Zum Führen des zu schaltenden elektrischen Stroms umfasst der mechanische Schalter üblicherweise mehrere Stromschienen, die meist in einer jeweiligen Aufnahme eines Gehäuses angeordnet sind, das als ein Kunststoffspritzgussteil ausgebildet ist. Somit werden die Stromschienen geeignet stabilisiert, wobei einer von diesen ein Festkontakt zugeordnet ist. Einer anderen Stromschiene ist ein Bewegkontakt zugeordnet, und diese ist beweglich gelagert, insbesondere mittels des Antriebs. Mittels Betriebs des Antriebs ist es dabei möglich, den Bewegkontakt an den Festkontakt mechanisch anzulegen oder diese zur voneinander zu beabstandeten. Der Antrieb wiederum wird mittels einer Steuereinheit betrieben, der eine Leiterplatte zugeordnet ist, und mittels derer auch etwaige Sensoren oder dergleichen ausgelesen werden, in Abhängigkeit derer der Antrieb betätigt wird. Die Bestromung der Steuereinheit erfolgt dabei üblicherweise unabhängig von dem Stromkreis, der mittels des mechanischen Schalters geschaltet wird. Daher ist meist der mechanische Schalter von der Leiterplatte beabstandet, weswegen Anforderungen an eine elektrische Isolation verringert sind.

Falls als Schalter der Halbleiterschalter verwendet wird, ist dieser meist direkt an der Leiterplatte befestigt und mit mehreren Leiterbahnen der Leiterplatte elektrisch kontaktiert. Da mittels des Halbleiterschalters vergleichsweise hohe elektrische Ströme getragen werden, ist es erforderlich, dass die Leiterbahnen eine vergleichsweise große Dicke aufweisen. Dies führt zu erhöhten Herstellungskosten der Leiterplatte.

Der Erfindung liegt die Aufgabe zugrunde, ein besonders geeignetes Schaltgerät anzugeben, wobei vorteilhafterweise Herstellungskosten reduziert sind, und wobei zweckmäßigerweise eine Herstellung vereinfacht und/oder eine Robustheit erhöht ist.

Erfindungsgemäß wird diese Aufgabe durch die Merkmale des Anspruchs 1 gelöst. Vorteilhafte Weiterbildungen und Ausgestaltungen sind Gegenstand der Unteransprüche.

Das Schaltgerät dient insbesondere dem Schalten eines elektrischen Stroms, also insbesondere dem Erstellen und/oder Unterbrechen eines elektrischen Stromflusses. Hierfür weist das Schaltgerät zweckmäßigerweise zwei Zustände auf, nämlich einen elektrisch leitenden Zustand, der auch als geschlossener Zustand bezeichnet wird. In diesem Fall ist es möglich, mittels des Schaltgeräts den elektrischen Strom zu führen. Bei dem anderen Zustand, der als geöffneter oder elektrisch nichtleitender Zustand bezeichnet wird, ist insbesondere ein elektrischer Stromfluss über das Schaltgerät nicht möglich. Beispielsweise ist das Schaltgerät manuell betätigt/betätigbar, sodass es sich bei dem Schaltgerät um einen Handschalter handelt. Alternativ oder in Kombination hierzu ist es zum Beispiel möglich, das Schaltgerät elektrisch zu betätigen und somit insbesondere aus der Ferne. In einer weiteren Alternative ist das Schaltgerät beispielsweise automatisch betätigt, zweckmäßigerweise in Abhängigkeit von bestimmten Bedingungen. Geeigneterweise ist das Schaltgerät ein Schutzschalter oder ein Schütz.

Der Schutzschalter dient zum Beispiel der Absicherung eines Geräts, und der Schutzschalter ist beispielsweise ein Geräteschutzschalter. Alternativ oder in Kombination hierzu dient der Schutzschalter der Absicherung einer Leitung und ist somit ein Leitungsschutzschalter. Insbesondere wird der Schutzschalter in einem Gleichspannungskreis eingesetzt, also zum Beispiel zwischen einer Last und einem Gleichspannungszwischenkreis oder dergleichen, sodass insbesondere ein Stromkreis gebildet ist. Vorzugsweise liegt hierbei im Gleichspannungskreis eine elektrische Gleichspannung zwischen 400 V und 650 V an, also insbesondere höherer Gleichspannung. Vorzugsweise wird der Schutzschalter zur Absicherung eines Aktors bei einer Industrieanlage verwendet. Der Aktor bildet hierbei insbesondere die Last. Zweckmäßigerweise wird der Schutzschalter im Bereich der Industrieautomation verwendet. Insbesondere ist die mittels des Schutzschalters geschaltete elektrische Spannung 24 V, 48 V, 380 V, 650 V, 760 V. Bei einer Alternative wird der Schutzschalter zur Absicherung einer Straßenbeleuchtung, eines Schiffsbordnetzes, Bahnanwendungen-Infrastruktur, Bahnanwendungen-Antrieb oder im Bereich der elektrifizierten Luftfahrt verwendet. Bei einer weiteren Alternative wird der Schutzschalter im Ausbau und Integration erneuerbarer Energieerzeuger, bei Inselnetzen, im privaten häuslichen Bereich, in Gewächshäusern, bei der Elektrifizierung straßengebundener Mobilität (Elektromobilität), Landwirtschaft oder bei Baustellenfahrzeugen verwendet. Die verwendete elektrische (Gleich-)Spannung ist dabei zum Beispiel zwischen 1500 V und 3000 V oder beträgt 110 V, 380 V, 400 V 800 V, 1000 V 1500 V, 3000 V. Zusammenfassend wird alternativ zur Anwendung bei einer Industrieanlage der Schutzschalter beispielsweise bei einem Elektrofahrzeug verwendet, wie einem Kraftfahrzeug, einem Flugzeug oder einem Schiff/Boot.

In einer Alternative hierzu ist beispielsweise das Schaltgerät als ein Trennschalter ausgebildet, der auch als Trenner bezeichnet wird. Beispielsweise umfasst das Schaltgerät einen mechanischen Hebel, mittels dessen der Schaltzustand des Steuergeräts verändert werden kann.

Das Schaltgerät umfasst insbesondere zwei Anschlüsse, zwischen denen zweckmäßigerweise ein Strompfad gebildet ist, und an dem im Montagezustand weitere Bestandteile des Stromkreises angeschlossen sind. Hierfür sind die Anschlüsse geeignet, insbesondere vorgesehen und eingerichtet. Zweckmäßigerweise ist hierfür an dem jeweiligen Anschluss ein Kabel oder eine Stromschiene angeschlossen, wobei ein Querschnitt dieser zum Beispiel zwischen 10 mm2 und 100 mm2 oder zwischen 25 mm2 und 92 mm2 ist. Der Querschnitt beträgt beispielsweise 16 mm2, 25 mm2 oder 35 mm2. Der Querschnitt ist beispielsweise 6 mm2, zwischen 6mm2 und 16 mm2 oder zwischen 16 mm2 und 50 mm2. Insbesondere sind die Anschlüsse nach Art von Käfigklemmen ausgebildet oder umfassen zumindest diese.

Das Schaltgerät weist einen mechanischen Schalter auf. Dabei ist der mechanische Schalter zweckmäßigerweise dem etwaigen Strompfad zugeordnet, also insbesondere elektrisch zwischen die beiden Anschlüsse des Schaltgeräts geschaltet. Somit ist es möglich, mittels des mechanischen Schalters den elektrischen Stromfluss über das Schaltgerät zu schalten. Der mechanische Schalter ist geeigneterweise in einem Gehäuse angeordnet, das vorzugsweise aus einem Kunststoff gefertigt ist. Somit ist ein Berührschutz für den mechanischen Schalter bereitgestellt, und dieser ist auch vor Umgebungseinflüssen geschützt.

Zweckmäßigerweise sind die etwaigen Anschlüsse in das Gehäuse eingebracht, sodass eine elektrische Kontaktierung des etwaigen Strompfads oder zumindest des mechanischen Schalters von außerhalb des Gehäuses ermöglicht ist.

Das Schaltgerät weist eine erste Stromschiene und eine zweite Stromschiene auf. Die erste Stromschiene umfasst einen ersten Festkontakt und die zweite Stromschiene einen ersten Bewegkontakt. Der erste Bewegkontakt ist dem ersten Festkontakt zugeordnet. Insbesondere ist die zweite Stromschiene beweglich gelagert, und es ist möglich, den ersten Bewegkontakt mechanisch an den ersten Festkontakt anzulegen und diese auch voneinander zu beabstanden. Bei der mechanisch direkten Anlage des ersten Bewegkontakts an dem ersten Festkontakt ist ein elektrischer Stromfluss über den mechanischen Schalter ermöglicht, insbesondere daher auch über das Schaltgerät. Falls hingegen der erste Bewegkontakt von dem ersten Festkontakt beabstandet ist, ist ein elektrischer Stromfluss nicht möglich, und zweckmäßigerweise sind dann die beiden etwaigen Anschlüsse voneinander galvanisch getrennt. Zumindest ist der Strompfad vorzugsweise aufgetrennt. Zumindest jedoch erfolgt über den mechanische Schalter kein elektrischer Stromfluss.

Der erste Festkontakt ist zum Beispiel an den anderen Bestandteilen der ersten Stromschiene befestigt und zweckmäßigerweise damit elektrisch kontaktiert. Zum Beispiel ist der erste Festkontakt einstückig mit den weiteren Bestandteilen der ersten Stromschiene und/oder an diese angeformt. Alternativ hierzu besteht der erste Festkontakt aus einem anderen Material, wie zum Beispiel ein Körper der ersten Stromschiene. Somit ist es möglich, dort eine Abbrandresistenz zu erhöhen. Zweckmäßigerweise ist der erste Festkontakt mit dem Körper der ersten Stromschiene vernietet, verlötet oder verschweißt. Zweckmäßigerweise ist die erste Stromschiene, insbesondere mit Ausnahme des ersten Festkontakts oder zumindest der Körper, aus einem Kupfer erstellt, vorzugsweise vernickeltem Kupfer.

Alternativ oder in Kombination hierzu ist insbesondere ist der erste Bewegkontakt an einen Körper der zweiten Stromschiene angeformt oder bevorzugt dort befestigt und auch elektrisch kontaktiert. Beispielsweise erfolgt dies ebenfalls mittels Nietens, Lötens oder Schweißens. Geeigneterweise bestehen die Körper der ersten und zweiten Stromschiene aus dem gleichen Material. Zweckmäßigerweise besteht der erste Festkontakt aus dem gleichen Material wie der erste Bewegkontakt. Somit können diese jeweils aus dem gleichen Halbzeug gefertigt werden, was eine Lagerhaltung vereinfacht.

Das Schaltgerät weist ferner eine Leiterplatte auf, die geeigneterweise einen Körper aus einem glasfaserverstärkten Epoxidharz umfasst. Insbesondere umfasst hierbei die Leiterplatte mehrere Leiterbahnen, die an dem Körper aus glasfaserverstärkten Epoxidharz befestigt und/oder in diesen eingebettet sind. Die Leiterbahnen sind zweckmäßigerweise aus einem Kupfer gefertigt. Die erste Stromschiene ist an der Leiterplatte montiert. Mit anderen Worten ist die erste Stromschiene nicht originär ein Bestandteil der Leiterplatte und somit nicht mittels Ätzens, Fräsens oder sonstigen abrasiver Verfahren erstellt, also mittels Abtragens von Bestandteilen der Leiterplatte. Vielmehr erfolgt das Anordnen der ersten Stromschiene an der Leiterplatte mittels eines additiven Verfahrens, sodass die erste Stromschiene insbesondere zu der bereits fertig erstellten Leiterplatte hinzugefügt wird.

Zum Beispiel wird die erste Stromschiene mittels Oberflächenmontage an der Leiterplatte befestigt, und die erste Stromschiene ist insbesondere als ein SMD-Bauteil ausgebildet. Hierfür weist die erste Stromschiene zweckmäßigerweise geeignete Pads auf. In einer Alternative ist beispielsweise die erste Stromschiene mittels Durchsteckmontage an der Leiterplatte montiert. Hierfür weist die erste Stromschiene zweckmäßigerweise geeignete Beinchen oder drahtartige Fortsätze auf, die in entsprechenden Löchern der Leiterplatte einliegen. Insbesondere wird zum Montieren die erste Stromschiene mit der Leiterplatte verlötet und/oder verklebt. In einer weiteren Alternative ist die erste Stromschiene mittels Einpresstechnik/Einpressverfahren an der Leiterplatten befestigt.

Aufgrund einer derartigen Ausgestaltung wird mittels der Leiterplatte insbesondere nicht der mittels des mechanischen Schalters geführte elektrische Strom geführt, sodass es nicht erforderlich ist, eine Stromtragfähigkeit der Leiterplatte übermäßig zu erhöhen. Somit sind Herstellungskosten reduziert. Dabei wird die erste Stromschiene mittels der Leiterplatte stabilisiert, weswegen eine Robustheit erhöht ist. Auch ist das Montieren der ersten Stromschiene an der Leiterplatte beispielsweise in einem Arbeitsschritt mit der Montage von weiteren Bestandteilen, wie elektrischen und/oder elektronischen Bauteilen, an der Leiterplatte möglich, sodass Arbeitsschritte eingespart werden können. Auch ist eine mechanisierte Fertigung ermöglicht, weswegen Herstellungskosten weiter reduziert sind.

Beispielsweise ist die erste Stromschiene elektrisch isoliert von weiteren Bestandteilen der Leiterplatte. Somit ist eine Sicherheit erhöht. Alternativ hierzu sind beispielsweise weitere Bestandteile des Schaltgeräts mittels der etwaigen Leiterbahnen der Leiterplatte mit der ersten Stromschiene elektrisch kontaktiert. Somit ist insbesondere ein Messen oder Ermitteln des mittels der ersten Stromschiene geführten elektrischen Stroms ermöglicht.

Beispielsweise ist die erste Stromschiene parallel zur Leiterplatte angeordnet und liegt zum Beispiel flächig auf dieser auf. Somit ist eine Stabilität erhöht. Alternativ hierzu ist ein Körper der ersten Stromschiene von der Leiterplatte beabstandet und wird zum Beispiel dort mittels entsprechender abgewinkelter Halter der ersten Stromschiene gehalten, die an der Leiterplatte befestigt sind. Somit ist ein elektrischer Kurzschluss mit weiteren an der Leiterplatte befestigten Bestandteilen vermieden. Auch steht auf diese Weise vergleichsweise viel Bauraum zur Montage der etwaigen elektrischen und/oder elektronischen Bauteile zur Verfügung. Besonders bevorzugt ist die erste Stromschiene senkrecht zu der Leiterplatte angeordnet. Mit anderen Worten ist die Leiterplatte insbesondere in einer Ebene angeordnet, und die erste Stromschiene, insbesondere der etwaige Körper der Stromschiene ist hierzu senkrechte angeordnet. Vorzugsweise ist dabei die erste Stromschiene im Wesentlichen streifenförmig ausgebildet, und weist somit vorwiegend eine Ausdehnung in einer Ebene auf. Diese Ebene ist dabei senkrecht zur Leiterplatte angeordnet. Geeigneterweise ist dabei der Verlauf der ersten Stromschiene, also deren Längsrichtung, zumindest im Bereich des ersten Festkontakts, parallel zur Leiterplatte. Somit ist einerseits ein Materialbedarf der ersten Stromschiene verringert. Andererseits steht auf diese Weise vergleichsweise viel Bauraum der Leiterplatte zur Anordnung der etwaigen elektrischen und/oder elektronischen Bauteilen zur Verfügung. Zweckmäßigerweise liegt dabei die erste Stromscheine randseitig auf der Leiterplatte auf. Somit ist eine Robustheit erhöht.

Beispielsweise ist die zweite Stromschiene schwenkbar gelagert. Besonders bevorzugt jedoch ist die zweite Stromschiene senkrecht zu deren Längsrichtung und/oder der Längsrichtung der ersten Stromschiene gelagert. Somit ist eine Konstruktion vereinfacht. Geeigneterweise umfasst der mechanische Schalter eine dritte Stromschiene mit einem zweiten Festkontakt, und die zweite Stromschiene umfasst einen zweiten Bewegkontakt. Hierbei ist der zweite Bewegkontakt dem zweiten Festkontakt zugeordnet. Somit werden insbesondere bei Bewegen der zweiten Stromschiene der zweite Bewegkontakt von dem zweiten Festkontakt und der erste Bewegkontakt von dem ersten Festkontakt wegbewegt oder aneinander mechanisch angelegt. Insbesondere ist folglich der mechanische Schalter nach Art eines Doppelunterbrechers ausgebildet, weswegen die zwischen jedem Festkontakt und dem zugeordneten Bewegkontakt anliegende elektrische Spannung im geöffneten Schaltzustand des mechanischen Schalters reduziert ist. Infolgedessen ist ein Ausbilden eines Lichtbogens dort unterbunden, oder dies erfolgt erst bei einer vergleichsweise hohen anliegenden elektrischen Spannung. Zweckmäßigerweise ist hierbei jedem Festkontakt und dem zugeordneten Bewegkontakt eine Löschkammer zugeordnet. Falls lediglich der erste Festkontakt und der erste Bewegkontakt vorhanden sind, ist diesen ebenfalls vorzugsweise die Löschkammer zugeordnet. Mittels der Löschkammer erfolgt dabei insbesondere ein Löschen des jeweiligen Lichtbogens. Hierfür umfasst die Löschkammer zweckmäßigerweise mehrere Löschbleche oder dergleichen.

Insbesondere sind hierbei alle Stromschienen im Wesentlichen senkrecht zur Leiterplatte angeordnet, wobei deren Verlauf, also insbesondere die Richtung, in die diese die größte Ausdehnung aufweisen, parallel zur Leiterplatte ist. Somit werden die Stromschienen mittels der Leiterplatte stabilisiert, wobei eine benötigte Baugröße verringert ist.

Beispielsweise wird zum Beabstanden der Bewegkontakte von dem jeweils zugeordneten Festkontakt die zweite Stromschiene verkippt, verschwenkt oder besonders bevorzugt transversal bewegt. Hierbei sind zum Beispiel einige der Stromschienen senkrecht oder quer zueinander angeordnet. Besonders bevorzugt jedoch sind sämtliche Stromschienen zueinander parallel. Somit ist eine Konstruktion vereinfacht, und ein Platzbedarf verringert. Besonders bevorzugt befinden sich hierbei um die erste Stromschiene und die dritte Stromschiene in einer gemeinsamen Ebene, die vorzugsweise senkrecht zur Leiterplatte ist. Somit ist eine Konstruktion weiter vereinfacht. Besonders bevorzugt ist der mechanische Schalter im Wesentlichen symmetrisch ausgebildet. Folglich ist die Konstruktion weiter vereinfacht, und insbesondere eine Anzahl an unterschiedlichen Bauteilen reduziert.

Beispielsweise ist der mechanische Schalter lediglich manuell betätigbar. Besonders bevorzugt jedoch ist ein Antrieb vorhanden, mittels dessen die zweite Stromschiene angetrieben ist. Somit ist es mittels Betriebs des Antriebs möglich, den Schaltzustand des mechanischen Schalters zu verändern. Beispielsweise ist es hierbei lediglich möglich, den Schaltzustand des mechanischen Schalters in eine Richtung zu verändern, also beispielsweise lediglich von dem elektrisch leitenden in den elektrisch nichtleitenden Zustand oder umgekehrt. Folglich ist die Konstruktion vereinfacht. Besonders bevorzugt jedoch ist es möglich, mittels des Antriebs den Schaltzustand des mechanischen Schalters in beide Richtungen zu verändern, also diesen sowohl in den elektrisch leitenden als auch in den elektrisch nichtleitenden Zustand zu versetzen. Somit ist eine Funktionalität erhöht. Beispielsweise ist der Antrieb mechanisch ausgebildet. Besonders bevorzugt jedoch ist der Antrieb elektrisch ausgebildet. Zum Beispiel bildet die Kombination aus dem mechanischen Schalter und dem Antrieb ein Relais. Zweckmäßigerweise umfasst der Antrieb eine elektrische Spule. Hierbei wird bei Betrieb des Antriebs geeigneterweise ein magnetisches Bauteil, beispielsweise ein Permanentmagnet oder ein ferromagnetisches Bauteil, innerhalb der Spule bewegt.

Der Antrieb ist zum Beispiel als "Moving Magnet Aktuator" ausgebildet. Dem "Moving Magnet Aktuator" ("Moving Magnet Actuator") ist dabei auch das magnetische Bauteil zugeordnet, das beweglich gelagert ist. Zudem weist der "Moving Magnet Aktuator" eine Antriebseinheit mit einer oder mehreren elektrischen Spulen auf, die bei Betätigung des Antriebs bestromt werden, sodass zwischen diesen und dem Bauteil eine magnetische Wechselwirkung erfolgt. Die elektrischen Spulen sind dabei ortsfest gehalten. Da die elektrische(n) Spule(n) stationär gehalten ist/sind, ist eine Konstruktion vereinfacht, und es sind, mit Ausnahme der für die Lagerung erforderlichen Komponenten keine weiteren beweglich Bauteile oder elektrischen Verbindungen zwischen den beweglichen Bauteilen erforderlich, nämlich dem Bauteil und den stationären Bauteilen des "Moving Magnet Aktuators", der im Weiteren auch lediglich als Aktuator bezeichnet ist. Somit ist auch eine Reibung verringert.

Vorzugsweise umfasst die Antriebseinheit zwei elektrische Spulen, die zum Beispiel baugleich sind. Zumindest jedoch sind die beiden elektrischen Spulen zueinander entlang einer Längsachse versetzt und konzentrisch zu dieser angeordnet. Das Bauteil befindet sich dabei insbesondere auf der Längsachse und ist entlang dieser beweglich gelagert. Dabei befindet sich bei einem Schaltzustand des mechanischen Schalters das Bauteil in einem zwischen den beiden elektrischen Spulen vorhandenen Luftspalt und wird dort beispielsweise mittels eines magnetischen Kurzschlussblechs gehalten. Im anderen Schaltzustand hingegen ist das Bauteil entlang der Längsachse versetzt.

Da die Anzahl der beweglichen Bestandteile des "Moving Magnet Aktuators", insbesondere lediglich das Bauteil, vergleichsweise gering ist, und diese insbesondere ein vergleichsweises geringes Gewicht aufweisen, ist eine Dynamik des Aktuators vergleichsweise hoch. Somit ist eine Trägheit beim Betätigen des mechanischen Schalters verringert. Infolgedessen ist mittels des Schaltgeräts ein vergleichsweises schnelles Schalten ermöglicht.

Vorzugsweise erfolgt mittels des Antriebs eine Lagerung der zweiten Stromschiene. Somit ist eine Anzahl an benötigten Bauteilen verringert. Beispielsweise ist der Antrieb hierbei von der Leiterplatte separat. Somit ist eine flexible Gestaltung ermöglicht. Auch ist es möglich, das Schaltgerät modular auszubilden, weswegen eine Vielseitigkeit verbessert ist. Besonders bevorzugt jedoch ist der Antrieb an der Leiterplatte angebunden. Somit wird der Antrieb auch mittels der Leiterplatte stabilisiert, was eine Robustheit erhöht. Auch erfolgt auf diese Weise eine vergleichsweise genaue Ausrichtung der zweiten Stromschiene bezüglich der ersten Stromschiene, weswegen ein Schaltverhalten des mechanischen Schalters verbessert ist. Zweckmäßigerweise ist in diesem Fall der Antrieb elektrisch ausgestaltet, und vorzugsweise sind die einzelnen Bestandteile des Antriebs, oder zumindest einige davon, mittels der Leiterplatte miteinander verschaltet. Somit ist eine Anzahl an benötigten Bauteilen und Herstellungskosten weiter verringert.

Vorzugsweise umfasst das Schaltgerät eine Steuereinheit, mittels derer der Antrieb betrieben ist. Hierbei ist die Steuereinheit zweckmäßigerweise mittels der Leiterplatte bereitgestellt. Mit anderen Worten umfasst die Leiterplatte mehrere elektrische und/oder elektronische Bauteile, die mittels einiger der Leiterbahnen der Leiterplatte miteinander verschaltet sind. Somit ist eine Verschaltung bereitgestellt, mittels derer insbesondere die Steuereinheit gebildet ist. Infolgedessen ist auch die Steuereinheit bezüglich des Antriebs stabilisiert, weswegen eine Robustheit weiter verbessert ist. Auch ist es beispielsweise möglich, die einzelnen Bestandteile der Steuereinheit und/oder des Antriebs und die erste Stromschiene in einem Arbeitsschritt an der Leiterplatte zu montieren. Folglich ist eine Herstellungszeit weiter verkürzt.

Zweckmäßigerweise umfasst das Schaltgerät mehrere Sensoren, die zum Beispiel mittels der Steuereinheit ausgelesen werden. Die Sensoren sind dabei zweckmäßigerweise ebenfalls an der Leiterplatte befestigt und mit einigen der Leiterbahnen der Leiterplatte mit der Steuereinheit elektrisch und somit signaltechnisch verbunden. Somit ist eine Herstellung weiter erleichtert und eine Robustheit weiter erhöht. Vorzugsweise ist zumindest einer der Sensoren der erste und/oder der etwaigen dritten Stromschiene zugeordnet. Somit ist insbesondere eine zwischen diesen anliegende elektrische Spannung und/oder ein damit geführter jeweiliger elektrische Strom erfassbar. Vorzugsweise wird der Antrieb in Abhängigkeit davon mittels der Steuereinheit betreiben, und das Schaltgerät ist in diesem Fall vorzugsweise als Schutzschalter ausgebildet.

Insbesondere umfasst das Schaltgerät eine Schnittstelle, die zum Beispiel mit der Steuereinheit signaltechnisch verbunden ist. In Abhängigkeit einer an der Schnittstelle anliegenden elektrischen Spannung und/oder darüber empfangenen Daten wird hierbei vorzugsweise der Antrieb betrieben. Die Schnittstelle ist vorzugsweise an der Leiterplatte angelötet. Somit ist auch hier eine Anzahl an benötigten Bauteilen verringert, und die Herstellung kann zum Beispiel im Wesentlichen lediglich automatisiert erfolgen.

Beispielsweise steht eine der Stromschienen über die Leiterplatte über. Besonders bevorzugt jedoch sind alle Stromschiene mittels der Leiterplatte abgedeckt. Mit anderen Worten steht in der Ausdehnungsebene der Leiterplatte keine der Stromschienen über den Rand der Leiterplatte über. Somit ist dort ein elektrischer Kurzschluss verhindert, und die Stromschienen werden mittels der Leiterplatte vergleichsweise stabil gehalten. Zusammenfassend weist somit die Leiterplatte eine größere Ausdehnung als die Stromschienen auf, und/oder die Stromschienen sind geeignet geformt/gebogen.

Beispielsweise liegt die zweite Stromschiene an der Leiterplatte an und wird zum Beispiel entlang und/oder mittels dieser geführt. Somit ist die zweite Stromschiene vergleichsweise stabil angeordnet, wobei jedoch insbesondere eine Reibung vergrößert ist. Bevorzugt ist daher die zweite Stromschiene von der Leiterplatte beabstandet. Somit ist eine Schaltgeschwindigkeit des mechanischen Schalters aufgrund der verringerten Reibung erhöht. Beispielsweise ist hierbei der Verlauf der zweiten Stromschiene im Wesentlichen senkrecht zum Verlauf der ersten Stromschiene und/oder zu der Leiterplatte.

Zweckmäßigerweise jedoch ist der Verlauf der zweiten Stromschiene im Wesentlichen parallel zur Ebene der Leiterplatte und/oder der ersten Stromschiene. Insbesondere weist dabei die erste Stromschiene einen Fortsatz auf, dem der erste Festkontakt zugeordnet ist. Mit anderen Worten ist der erste Festkontakt an dem Fortsatz angeordnet, und mittels dessen somit von der Leiterplatte beabstandet. Folglich ist es möglich, die erste Stromschiene mittels der Leiterplatte zu stabilisieren, wobei eine Bewegung der zweiten Stromschiene mittels der Leiterplatte nicht behindert wird. Beispielsweise ist die erste Stromschiene im Wesentlichen L-förmig, wobei einer der Schenkel randseitig zweckmäßigerweise an der Leiterplatte anliegt. Der andere Schenkel verläuft vorzugsweise senkrecht zur Leiterplatte, und an diesem ist, zweckmäßigerweise endseitig, der erste Festkontakt angeordnet. Besonders bevorzugt jedoch ist die erste Stromschiene im Wesentlichen U-förmig. Mit anderen Worten ist zusätzlich ein weiterer Schenkel vorhanden, der von der Leiterplatte beabstandet ist, und parallel zu der Leiterplatte verläuft. Beispielsweise ist in dieser endseitig frei schwingend oder festgehalten. Aufgrund der U-Form ist eine Stabilität erhöht. Zudem ist, ebenso, wie bei der L-förmigen Ausgestaltung der ersten Stromschiene, aufgrund der Lorentzkraft eine Konzentration des Magnetfelds vorhanden, wenn ein elektrischer Strom fließt, das entgegengesetzt zu dem mittels der zweiten Stromschiene bereitgestellten Magnetfeld ist. Somit stoßen sich die beiden Stromschienen ab, weswegen eine Öffnungsbewegung des mechanischen Schalters beschleunigt ist, ohne dass hierfür mittels des etwaigen Antriebs eine vergleichsweise hohe Kraft aufgebracht werden muss. Vielmehr ist es zum Beispiel lediglich erforderlich, die beiden Stromschienen festzuhalten, sodass der erste Bewegkontakt an dem ersten Festkontakt gehalten ist, zumindest solange der elektrische Stromfluss über das Schaltgerät bestehen soll.

Beispielsweise ist das Schaltgerät lediglich mechanisch ausgestaltet. Alternativ hierzu umfasst das Schaltgerät zudem einen Halbleiterschalter, der beispielsweise ein Feldeffekttransistor ist. Insbesondere ist der Halbleiterschalter ein Leistungshalbleiterschalter, wie ein MOSFET, JFET, GTO oder IGBT. Beispielsweise ist der Halbleiterschalter von der Leiterplatte beabstandet. Besonders bevorzugt ist der Halbleiterschalter an der Leiterplatte montiert und somit elektrisch mit dieser kontaktiert sowie dort befestigt. Dabei ist auch weiterhin zumindest teilweise eine mechanisierte Fertigung des Schaltgeräts ermöglicht. Auch ist es möglich, den Halbleiterschalter in einem Arbeitsschritt mit der Montage von zum Beispiel der etwaigen Steuereinheit oder der ersten Stromschiene an der Leiterplatte zu montieren. Vorzugsweise ist der Halbleiterschalter mittels einer Oberflächenmontage an der Leiterplatte befestigt. Somit erfolgt eine Stabilisierung des Halbleiterschalters, und eine Anzahl an benötigten Bauteilen ist verringert. Insbesondere umfasst die Leiterplatte eine Treiberschaltung, oder diese ist zumindest an der Leiterplatte montiert oder geeigneterweise mittels dieser bereitgestellt. Somit ist ein Betrieb des Halbleiterschalters mittels der Leiterplatte ermöglicht, weswegen eine Anzahl an benötigten Bauteilen weiter verringert ist.

Zweckmäßigerweise ist an der Leiterplatte eine weitere Stromschiene montiert, die elektrisch gegen einen der etwaigen Anschlüsse geführt ist. Auch ist die weitere Stromschiene von der ersten Stromschiene beabstandet. Insbesondere sind diese zueinander getrennt. Somit ist ein elektrischer Kurzschluss zwischen der ersten Stromschiene und der weiteren Stromschiene vermieden. Die weitere Stromschiene und die erste Stromschiene sind zweckmäßigerweise mittels des Halbleiterschalters miteinander elektrisch kontaktiert. Somit ist es möglich, einen elektrischen Stromfluss zwischen der weiteren Stromschiene und der ersten Stromschiene mittels des Halbleiterschalters zu unterbrechen oder zu erstellen. Aufgrund der beiden Stromschienen wird mittels der Leiterplatte lediglich über einen vergleichsweisen kurzen Abschnitt ein hoher elektrischer Strom zu dem Halbleiterschalter geführt, weswegen Anforderungen an die Leiterplatte verringert sind.

Beispielsweise ist der Halbleiterschalter elektrisch parallel zu dem mechanischen Schalter geschaltet. Hierbei ist die weitere Stromschiene zweckmäßigerweise niederohmig mit der zweiten Stromschiene elektrisch kontaktiert, beispielsweise über die etwaige Leiterbahnen der Leiterplatte, oder direkt. Alternativ hierzu wird zum Beispiel eine weitere zusätzliche Stromschiene herangezogen, die elektrisch mit der zweiten Stromschiene sowie der weiteren Stromschiene kontaktiert ist. In einer anderen Weiterbildung ist die weitere Stromschiene an die zweite Stromschiene angeformt. Besonders bevorzugt wird, bevor der mechanische Schalter geöffnet wird, der Halbleiterschalter in den elektrisch leitfähigen Zustand versetzt. Beim Beabstanden des ersten Bewegkontakts von dem erste Festkontakt kommutiert somit der elektrische Strom auf den Halbleiterschalter über, sodass sich zum Beispiel kein Lichtbogen zwischen dem ersten Bewegkontakt und dem ersten Festkontakt ausgebildet. Wenn diese weit genug voneinander beabstandet sind, wird zweckmäßigerweise der Halbleiterschalter in den elektrisch nichtleitenden Zustand versetzt. Somit ist der elektrische Stromfluss über das Schaltgerät unterbunden. Aufgrund des mechanischen Schalters sind im Normalbetrieb lediglich geringe elektrische Widerstände vorhanden, insbesondere im Vergleich zu lediglich der Verwendung des Halbleiterschalters, weswegen ein Wirkungsgrad verbessert ist.

In einer Alternative ist der Halbleiterschalter zweckmäßigerweise elektrisch in Reihe zu dem mechanischen Schalter geschaltet. Somit befindet sich der Halbleiterschalter elektrisch zwischen der zweiten Stromschiene und der weiteren Stromschiene. Auf diese Weise ist es beispielsweise möglich, zunächst mittels des Halbleiterschalters den elektrischen Strom über das Schaltgerät zu unterbrechen, und anschließend den mechanischen Schalter in den geöffneten Zustand zu versetzen. Auch hier erfolgt kein Ausbilden eines Lichtbogens, wobei jedoch die etwaigen Anschlüsse aufgrund des mechanischen Schalters zueinander galvanisch getrennt sind.

Insbesondere ist die weitere Stromschiene gegen einen der Anschlüsse geführt und vorzugsweise mit diesem elektrisch kontaktiert. Somit wird von dem Anschluss bis zur weiteren Stromschiene / dem Halbleiterschalter der elektrische Strom nicht mittels der Leiterplatte oder einem sonstigen Bauteil geführt, weswegen eine Montage und Herstellung erleichtert ist. Auch ist eine Anzahl an benötigten Bauteilen verringert.

Beispielsweise ist lediglich der einzige Halbleiterschalter vorhanden. Beispielsweise ist der Halbleiterschalter direkt gegen die Stromschiene sowie die weitere Stromschiene geführt. Alternativ hierzu ist beispielsweise ein weiterer Halbleiterschalter vorhanden, und diese sind elektrisch in Reihe geschaltet, nämlich zwischen die weitere Stromschiene und die erste Stromschiene. Somit ist die mittels jedes der Halbleiterschalter geschaltete elektrische Spannung verringert, weswegen Anforderungen an diese reduziert sind. Alternativ hierzu sind diese beispielsweise zueinander antiparallel orientiert. Infolgedessen ist es möglich, das Schaltgerät bidirektional zu betreiben. In einer weiteren Alternative sind die beiden Halbleiterschalter zueinander elektrisch in Reihe geschaltet. Somit teilt sich der elektrische Stromfluss über das Schaltgerät auf die einzelnen Halbleiterschalter auf, weswegen Anforderungen an diese verringert sind. Somit sind Herstellungskosten reduziert.

Vorzugsweise sind mehrere Halbleiterschalter vorhanden, wobei mehrere Stränge gebildet sind, die zweckmäßigerweise zueinander baugleich sind. Jeder Strang weist dabei mehrere der Halbleiterschalter auf, die elektrisch in Reihe geschaltet sind. Die Stränge wiederum sind elektrisch parallel zwischen die erste und die weitere Stromschiene geschaltet. Somit ergibt sich eine Aufteilung des elektrischen Stroms auf die unterschiedlichen Stränge, wobei die mittels jedes der Halbleiterschalter geschaltete elektrischen Spannung verringert ist. Somit sind die Anforderungen an die Halbleiterschalter weiter verringert.

Sofern der oder die weiteren Halbleiterschalter vorhanden sind, werden diese zweckmäßigerweise gleichzeitig zu dem Halbleiterschalter betätigt. Vorzugsweise sind alle Halbleiterschalter zueinander baugleich, was eine Lagerhaltung vereinfacht.

Zweckmäßigerweise sind die weitere Stromschiene und die erste Stromschiene zueinander parallel und entlang einer Längsrichtung angeordnet. Hierbei sind die weitere Stromschiene und die erste Stromschiene zueinander beabstandet, und zwischen diesen ist senkrecht zur Längsrichtung ein Überlapp gebildet. Dabei befindet sich der Überlapp in Längsrichtung zwischen dem Anschluss und dem ersten Festkontakt. Der Halbleiterschalter und der oder die weiteren Halbleiterschalter, vorzugsweise sämtliche etwaige Halbleiterschalter, sind im Bereich des Überlapps mit der weiteren Stromschiene und der ersten Stromschiene elektrisch kontaktiert. Insbesondere sind dabei die Halbleiterschalter zueinander parallelgeschaltet. Vorzugsweise sind die Stränge vorhanden, die zueinander elektrisch parallel geschaltet und im Bereich des Überlapps mit der weiteren Stromschiene und der ersten Stromschiene elektrisch kontaktiert sind. Infolgedessen ist Länge des Pfads für den elektrischer Strom zwischen dem Anschluss und dem ersten Festkontakt stets gleich, unabhängig davon, über welchen Halbleiterschalter der elektrische Strom fließt. Infolgedessen erfolgt eine im Wesentlichen gleichmäßige Aufteilung auf die Halbleiterschalter/Stränge, weswegen eine Überbelastung vermieden ist.

Zusammenfassend sind die Halbleiterschalter/Stränge insbesondere symmetrisch angeordnet.

Beispielsweise sind die Halbleiterschalter zueinander unterschiedlich oder vorzugsweise zueinander baugleich. Somit können Gleichteile verwendet werden. Auch ist ein im Wesentlichen gleichmäßiges Aufteilen des elektrischen Stroms auf die Halbleiterschalter sichergestellt, da diese die gleichen elektrischen Eigenschaften aufweisen.

Besonders bevorzugt wird das Schaltgerät zur Gleichspannungs- und/oder Gleichstromunterbrechung verwendet. Zweckmäßigerweise wird das Schaltgerät in einem Kraftfahrzeug oder einer Industrieanlage verwendet. Die Erfindung betrifft dabei auch die entsprechende Verwendung des Schaltgerät, das bevorzugt ein Schutzschalter ist. Auch betrifft die Erfindung einen Stromkreis, der ein derartiges Schaltgerät aufweist. Hierbei umfasst der Stromkreis zweckmäßigerweise eine Gleichspannungsquelle sowie eine Last. Insbesondere ist der Stromkreis ein Bestandteil eines Kraftfahrzeugs. Die Gleichspannungsquelle ist zum Beispiel ein Energiespeicher, wie eine Hochvoltbatterie, und die Last ist zum Beispiel ein Elektromotor oder zumindest ein Antrieb, der den Elektromotor umfasst. In diesem Fall kann die Last auch als Quelle fungieren, nämlich in einem generatorischen Betrieb des Elektromotors, der zu einem Abbremsen des Kraftfahrzeugs führt. In dem Stromkreis ist daher zum Beispiel die Stromrichtung bidirektional.

Das Schaltgerät ist zweckmäßigerweise als ein Schutzschalter ausgebildet. Hierbei wird der mechanische Schalter geeigneterweise in Abhängigkeit einer Auslösekennlinie betrieben. Vorzugsweise wird hierbei der mechanische Schalter mittels des Antriebs geöffnet, wenn ein elektrischer Strom für eine bestimmte Zeitspanne geführt wurde, die mittels der Auslösekennlinie vorgegeben ist. Zweckmäßigerweise ist hierbei die Steuereinheit vorhanden und/oder ein Sensor zum Erfassen des mittels des Schutzschalters geführten elektrischen Stroms. Der Sensor umfasst vorzugsweise einen Shunt. Die Erfindung betrifft auch einen derartigen Schutzschalter.

Die im Zusammenhang mit dem Schaltgerät erläuterten Weiterbildungen und Vorteile sind sinngemäß auch auf die Verwendung / den Stromkreis / den Schutzschalter sowie untereinander zu übertragen und umgekehrt.

Nachfolgend wird ein Ausführungsbeispiel der Erfindung anhand einer Zeichnung näher erläutert. Darin zeigen:
- Fig. 1: schematisch einen Gleichspannungskreis mit einer Last und einem Schutzschalter,
- Fig. 2: perspektivisch den Schutzschalter, der ein Gehäuse mit zwei Gehäusehälften umfasst, und
- Fig. 3: perspektivisch den Schutzschalter, wobei eine der Gehäusehälften entfernt ist.

Einander entsprechende Teile sind in allen Figuren mit den gleichen Bezugszeichen versehen.

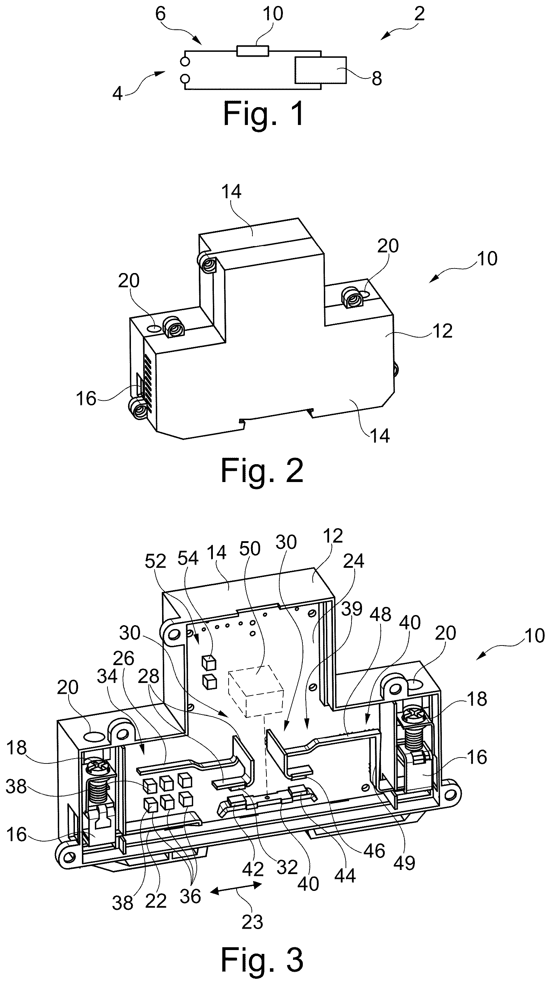

In Figur 1 ist schematisch vereinfacht ein Gleichspannungskreis 2 dargestellt, der eine Gleichspannungsquelle 4 umfasst. Mittels dieser wird eine elektrische Gleichspannung von 650 V bereitgestellt, und mittels dieser ist ein Gleichspannungszwischenkreis 6 gespeist. Mittels dessen ist eine Last 8 versorgt, die über ein Schaltgerät 10 mit dem Gleichspannungszwischenkreis 6 elektrisch verbunden ist. Hierbei ist es zum Beispiel möglich, dass in bestimmten Zuständen die Last 8 als Quelle fungiert. Somit ist der Gleichspannungskreis 2 bidirektional ausgebildet.

In Figur 2 ist perspektivisch das Schaltgerät 10 dargestellt, das als ein Schutzschalter ausgebildet ist. Das Schaltgerät 10 weist ein in Gehäuse 12 mit zwei Gehäusehälften 14 auf, die aneinandergefügt sind und aus einem Kunststoff gefertigt sind. In Figur 3 ist perspektivisch das Schaltgerät 10 dargestellt, wobei eine der beiden Gehäusehälften 14 entfernt ist. In das Gehäuse 12 sind zwei Öffnungen eingebracht, innerhalb derer jeweils ein Anschluss 16 angeordnet ist. Dort ist das Anschließen einer Leitung des Gleichspannungszwischenkreises 6 bzw. einer der Last 8 zugeordneten elektrischen Leitung ermöglicht. Die Anschlüsse 16 weisen jeweils eine Klemmschraube 18 auf, die durch eine Montageöffnung 20 des Gehäuses 12 zugänglich ist. Mittels Eindrehens der Klemmschrauben 18 wird die dem jeweiligen Anschluss 16 zugeordnete Leitung geklemmt und folglich elektrisch kontaktiert.

Einer der Anschlüsse 16 ist mit einer weiteren Stromschiene 22 elektrisch kontaktiert, die aus einem verzinnten Kupfer erstellt ist. Die weitere Stromschiene 22 ist streifenförmig und im Wesentlichen lediglich in einer Ebene angeordnet. Dabei ist eine in der Ebene liegende Längsrichtung 23 der weiteren Stromschiene 2 von dem zugeordneten Anschluss 16 zu dem verbleibenden Anschlusses 16 gerichtet, von dem die weitere Stromschiene 22 beabstandet ist.

Die weitere Stromschiene 22 ist senkrecht zu einer Leiterplatte 24 angeordnet und liegt randseitig an dieser an. Somit verläuft die Ebene, in der die weitere Stromschiene 2 liegt, senkrecht zur Ebene, in der die Leiterplatte 24 liegt, wobei die Längsrichtung 23 parallel zur Leiterplatte 24 ist. Auch ist die weitere Stromschiene 22 an der Leiterplatte 24 montiert, nämlich mittels Durchsteckmontage. Hierfür weist der Rand der weiteren Stromschiene 22 mehrere nicht näher dargestellte drahtartige Fortsätze auf, die durch Leiterplatte 24 gesteckt und mit dieser verlötet sind.

Parallel zu der weiteren Stromschiene 22, jedoch bezüglich dieser seitlich versetzt, ist an der Leiterplatte 24 eine erste Stromschiene 26 montiert. Dabei liegt die erste Stromschiene 26 ebenfalls randseitig auf der Leiterplatte 24 auf und weist entsprechende drahtartige Fortsätze auf, die durch geeignete Öffnungen der Leiterplatte 24 geführt und dort verlötet sind. Somit ist die erste Stromschiene 26 ebenfalls senkrecht zur Leiterplatte 24 angeordnet und vorwiegend in der Längsrichtung 23 orientiert. Zusammenfassend ist die weitere Stromschiene 22 gegen einen der Anschlüsse 16 geführt und von der ersten Stromschiene 26 beabstandet.

Die Form der ersten Stromschiene 26 ist im Wesentlichen u-förmig, sodass zusätzlich zu dem an der Leiterplatte 24 anliegenden Teil der ersten Stromschiene 26 zwei Schenkel 28 vorhanden sind, mittels derer ein Fortsatz 30 gebildet ist, der von der Leiterplatte 24 beabstandet ist. Einer der Schenkel 28 ist dabei parallel zur Längsrichtung 23 und der andere hierzu senkrecht angeordnet. Dem Fortsatz 30 ist ein erster Festkontakt 32 der ersten Stromschiene 26 zugeordnet, der aus einem anderen Material als der Fortsatz 30 gefertigt und mit diesem verschweißt ist. Der erste Festkontakt 32 ist hierbei aufgrund des Fortsatz 30 von der Leiterplatte 24 beabstandet.

In der Längsrichtung 32 ist zwischen dem Festkontakt 32 und dem Anschluss 16, gegen den die weitere Stromschiene 20 geführt ist, ein Überlapp 34 gebildet. Mit anderen Worten überlappen sich die erste Stromschiene 26 und die weitere Stromschiene 22 jeweils endseitig in Längsrichtung 23. Im Bereich des Überlapps 34 sind die weitere Stromschiene 22 und die erste Stromschiene 26 mittels mehrerer Stränge 36 elektrisch kontaktiert, die elektrisch parallel geschaltet sind. Jeder der Stränge 36 umfasst zwei Halbleiterschalter 38, die elektrisch in Reihe geschaltet sind. Die Halbleiterschalter 38 sind zueinander baugleich und als MOSFETs ausgebildet. Auch sind die Halbleiterschalter 38 an der Leiterplatte 24 montiert, nämlich mittels Oberflächenmontage. Mit anderen Worten sind die Halbleiterschalter 38 SMD-Bauteile.

Zusammenfassend sind die weitere Stromschiene 22 und die erste Stromschiene 26 sind derart parallel zueinander und entlang der Längsrichtung 23 angeordnet, dass in Längsrichtung 23 zwischen dem zugeordneten Anschluss 16 und dem ersten Festkontakt 32 der Überlapp 34 gebildet ist. Dabei sind die Halbleiterschalter 38 im Bereich des Überlapps 34 mit der weiteren Stromschiene 22 und der ersten Stromschiene 26 elektrisch kontaktiert. Aufgrund einer derartigen Anordnung ist die Länge zwischen dem Anschluss 16 und dem Festkontakt 32 für den elektrischen Strom stets gleich, unabhängig davon, welche der Stränge 36 von dem elektrischen Strom durchflossen ist.

Die erste Stromschiene 26, die den ersten Festkontakt 32 umfasst, ist ein Bestandteil eines mechanischen Schalters 39, der zudem eine zweite Stromschiene 40 mit einem ersten Bewegkontakt 42 und einem zweiten Bewegkontakt 44 aufweist. Die zweite Stromschiene 14 erstreckt sich ebenfalls in Längsrichtung 23, ist jedoch von der Leiterplatte 24 beabstandet. Dabei ist der erste Bewegkontakt 42 dem ersten Festkontakt 32 zugeordnet, und der zweite Bewegkontakt 44 ist einem zweiten Festkontakt 46 einer dritten Stromschiene 48 des mechanischen Schalters 39 zugeordnet, die im Wesentlichen achsensymmetrisch zu der ersten Stromschiene 26 ausgebildet und entsprechend angeordnet ist. Somit weist die dritte Stromschiene 48 ebenfalls den Fortsatz 30 auf, dem der zweite Festkontakt 46 zugeordnet ist, der von der Leiterplatte 24 beabstandet ist. Mit Ausnahme des Fortsatzes 30 liegt auch die dritte Stromschiene 48 randseitig an der Leiterplatte 24 an und ist an dieser montiert. Auch ist die dritte Stromschiene 48 in der gleichen Ebene wie die erste Stromschiene 26 angeordnet. Folglich sind die erste Stromschiene 26, die zweite Stromschiene 40 und die dritte Stromschiene 48 im Wesentlichen parallel zueinander angeordnet.

Hierbei sind sämtliche Stromschienen 26, 40, 48 des mechanischen Schalters 39 von dem Rand der Leiterplatte 24 beabstandet, weswegen diese mittels der Leiterplatte 24 abgedeckt sind. Mit anderen Worten steht keine dieser Stromschiene 26, 40, 48 über die Leiterplatte 24 über, sodass ein elektrischer Kurzschluss vermieden ist.

An das dem Fortsatz 30 gegenüberliegende Ende der dritten Stromschiene 48 ist eine zusätzliche Stromschiene 49 angeformt, die senkrecht zur Längsrichtung 23 verläuft, und gegen den verbleibenden Anschluss 16 geführt ist. Somit sind die beiden Anschlüsse 16 mittels der zusätzlichen Stromschiene 49, des mechanischen Schalters 39, der Stränge 36 sowie der weiteren Stromschiene 22 elektrisch miteinander verbunden.

Die zweite Stromschiene 40 ist mittels eines Antriebs 50 angetrieben und senkrecht zur Längsrichtung 23 und parallel zur Leiterplatte 24 beweglich gelagert. Somit ist es möglich, mittels des Antriebs 50 die zweite Stromschiene 40 senkrecht zur Längsrichtung 23 und parallel zur Leiterplatte 24 zu verbringen. Hierbei ist es möglich, den erste Bewegkontakt 42 in mechanisch direkten Kontakt mit dem ersten Festkontakt 32 zu verbringen, wobei dann auch der zweite Bewegkontakt 44 an dem zweiten Festkontakt 46 anliegt. Wenn dann die Halbleiterschalter 38 elektrisch leitend geschaltet sind, ist ein elektrischer Stromfluss zwischen den Anschlüssen 16 möglich. Auch ist es möglich, mittels des Antriebs 50 die zweite Stromschiene 40 derart zu bewegen, dass die Bewegkontakte 42, 44 von den Festkontakten 32, 46 beabstandet sind. Folglich ist ein elektrischer Stromfluss zwischen den Anschlüssen 16 unterbunden, auch wenn die Halbleiterschalter 38 elektrisch leitfähig sind.

Der Antrieb 50 ist an der Leiterplatte 24 angebunden und somit stabilisiert. Folglich ist keine Ausrichtung der zweiten Stromschiene 40 erforderlich, da deren Position anhand der Montageposition des Antriebs 50 und somit mittels der Leiterplatte 24 bestimmt ist, anhand derer auch die Position der ersten und dritten Stromschiene 26, 48 vorgegeben wird. Der Antrieb 50 ist mittels einer Steuereinheit 52 betrieben, die mehrere elektrische und/oder elektronische Bauteile 54 aufweist. Hierbei werden auch die Halbleiterschalter 38 mittels der Steuereinheit 52 betrieben, also in den elektrisch leitfähigen oder elektrisch nicht leitfähigen Zustand versetzt. Die Bauteile 54 sind mittels nicht näher dargestellter Leiterbahnen der Leiterplatte 24 miteinander verschaltet, sodass mittels der Leiterplatte 24 die Steuereinheit 52 bereitgestellt ist, mittels derer der Antrieb 50 betrieben ist, mittels dessen wiederum die zweite Stromschiene 40 angetrieben ist. Dabei erfolgt die elektrische Kontaktierung des Antriebs 50 mit der Steuereinheit 52 mittels der Leiterbahnen der Leiterplatte 24, weswegen keine gesonderte Verkabelung erforderlich ist, was die Montage vereinfacht.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebenen Einzelmerkmale auch auf andere Weise miteinander kombinierbar, ohne den Gegenstand der Erfindung zu verlassen.

### Bezugszeichenliste

- 2: Gleichspannungskreis
- 4: Gleichspannungsquelle
- 6: Gleichspannungszwischenkreis
- 8: Last
- 10: Schaltgerät
- 12: Gehäuse
- 14: Gehäusehälfte
- 16: Anschluss
- 18: Klemmschraube
- 20: Montageöffnung
- 22: weitere Stromschiene
- 23: Längsrichtung
- 24: Leiterplatte
- 26: erste Stromschiene
- 28: Schenkel
- 30: Fortsatz
- 32: erster Festkontakt
- 34: Überlapp
- 36: Strang
- 38: Halbleiterschalter
- 39: mechanischer Schalter
- 40: zweite Stromschiene
- 42: erster Bewegkontakt
- 44: zweiter Bewegkontakt
- 46: zweiter Festkontakt
- 48: dritte Stromschiene
- 50: Antrieb
- 52: Steuereinheit
- 54: Bauteil

## Patentansprüche

1. Schaltgerät (10) mit einem mechanischen Schalter (39), der eine erste Stromschiene (26) mit einem ersten Festkontakt (32) und eine zweite Stromschiene (40) mit einem ersten Bewegkontakt (42) aufweist, der dem ersten Festkontakt (32) zugordnet ist, und mit einer Leiterplatte (24), an der die erste Stromschiene (26) montiert ist.

2. Schaltgerät (10) nach Anspruch 1,
**dadurch gekennzeichnet,**
**dass** die erste Stromschiene (26) senkrecht zu der Leiterplatte (24) angeordnet ist.

3. Schaltgerät (10) nach Anspruch 1 oder 2,
**dadurch gekennzeichnet,**
**dass** der mechanischen Schalter (39) eine dritte Stromschiene (48) mit einem zweiten Festkontakt (46) aufweist, und dass die zweite Stromschiene (40) einen zweiten Bewegkontakt (44) umfasst, der dem zweiten Festkontakt (46) zugeordnet ist.

4. Schaltgerät (10) nach Anspruch 3,
**dadurch gekennzeichnet,**
**dass** alle Stromschienen (26, 40, 48) zueinander parallel sind.

5. Schaltgerät (10) nach einem der Ansprüche 1 bis 4,
**dadurch gekennzeichnet,**
**dass** an der Leiterplatte (24) ein Antrieb (50) angebunden ist, mittels dessen die zweite Stromschiene (40) angetrieben ist.

6. Schaltgerät (10) nach Anspruch 5,
**dadurch gekennzeichnet,**
**dass** mittels der Leiterplatte (24) eine Steuereinheit (52) bereitgestellt ist, mittels derer der Antrieb (50) betrieben ist.

7. Schaltgerät (10) nach einem der Ansprüche 1 bis 6,
**dadurch gekennzeichnet,**
**dass** alle Stromschienen (26, 40, 48) mittels der Leiterplatte (24) abgedeckt sind.

8. Schaltgerät (10) nach einem der Ansprüche 1 bis 7,
**dadurch gekennzeichnet,**
**dass** die erste Stromschiene (26) einen Fortsatz (30) aufweist, dem der erste Festkontakt (32) zugeordnet ist, wobei der erste Festkontakt (32) und die zweite Stromschiene (40) von der Leiterplatte (24) beabstandet sind.

9. Schaltgerät (10) nach einem der Ansprüche 1 bis 8,
**dadurch gekennzeichnet,**
**dass** an der Leiterplatte (24) eine weitere Stromschiene (22) montiert ist, die elektrisch gegen einen Anschluss (16) geführt und von der ersten Stromschiene (26) beabstandet ist, wobei die weitere Stromschiene (22) und die erste Stromschiene (26) mittels eines an der Leiterplatte (24) montierten Halbleiterschalters (38) miteinander elektrisch kontaktiert sind.

10. Schaltgerät (10) nach Anspruch 9,
**dadurch gekennzeichnet,**
**dass** die weitere Stromschiene (22) und die erste Stromschiene (26) derart zueinander parallel und entlang einer Längsrichtung (23) angeordnet sind, dass in Längsrichtung (23) zwischen dem Anschluss (16) und dem ersten Festkontakt (32) ein Überlapp (34) gebildet ist, wobei der Halbleiterschalter (38) und ein weiterer Halbleiterschalter (38) im Bereich des Überlapps (36) mit der weiteren Stromschiene (22) und der ersten Stromschiene (26) elektrisch kontaktiert sind.
